# EUROPEAN PATENT APPLICATION

(11) **EP 4 464 480 A1**
(43) Date of publication of application: **20.11.2024**
(21) Application number: 23173452.6
(22) Date of filing: 15.05.2023
(51) Int. Cl.: B26D 1/00, B26B 21/58, B26B 21/60, B32B 15/00, B32B 18/00

(54) **COMPOSITE OF A SUBSTRATE WITH A STRUCTURED COATING, CUTTING ELEMENT AND METHOD FOR PRODUCING A CUTTING ELEMENT**

(71) Applicant: GFD Gesellschaft für Diamantprodukte mbH, 89231 Ulm (DE)
(72) Inventor: Gluche, Peter, 89287 Bellenberg (DE); Mertens, Michael, 89269 Vöhringen/Illerberg (DE); Gretzschel, Ralph, 89231 Neu-Ulm/Offenhausen (DE)
(74) Representative: Pfenning, Meinig & Partner mbB

(57) **Abstract**

The present invention relates to a composite of a substrate coated with a structured coating comprising a substrate with a surface in contact with the coating. The substrate has a plurality of substrate recesses at least in regions of the substrate surface. The coating extends into the recesses of the substrate and the coating has an inner surface being in contact with the substrate and an outer surface opposite to the inner surface. The coating comprises at the outer surface a plurality of coating recesses being smaller than the recesses at the surface of the substrate resulting in a structured coating. Moreover, the present invention relates to a cutting element formed from the composite and a method for producing a cutting element.

## Description

The present invention relates to a composite of a substrate coated with a structured coating comprising a substrate with a surface in contact with the coating. The substrate has a plurality of substrate recesses at least in regions of the substrate surface. The coating extends into the recesses of the substrate and the coating has an inner surface being in contact with the substrate and an outer surface opposite to the inner surface. The coating comprises at the outer surface a plurality of coating recesses being smaller than the recesses at the surface of the substrate resulting in a structured coating. Moreover, the present invention relates to a cutting element formed from the composite and a method for producing a cutting element.

For many engineering applications, substrate materials are coated with a soft or hard material coating layer to enhance the performance of the substrate material. For instance, hard coatings are applied to increase wear resistance of the substrate material or soft coatings are applied to improve the friction properties of the substrate material. Thus, the substrate material plus the coating form a layered composite material with enhanced functional properties.

For lubricated applications, it is also known to structure the contact surface in order to provide reservoirs for the lubricant.

However, there are many applications that are operated in absence of lubricants, e.g. in cutting processes.

For such applications, to tailor the friction and wear properties, a complex stack of materials can be applied, e.g. for razor blades a steel substrate having planar cutting bevels is first coated with a diamond like carbon (DLC) hard coating to improve the wear resistance, followed by a friction reduction layer of polytetrafluoroethylene (PTFE). Utilizing a stack of layers to achieve a specified compromise of wear resistance and friction properties is complex and costly. In addition, a stack of different layers may cause problems by the different materials properties e.g. different Youngs' moduli may induce shear stress at the layer interfaces when mechanical deformation is applied to the stack. This may lead to catastrophic failure by delamination of at least parts of the layers. Furthermore, a stack of layers may show up thermal induced stress resulting in stack deformation, especially if the layers are deposited at different temperatures and having different thermal expansion coefficients.

Additionally, all coatings on a cutting edge will increase the radius of curvature of the cutting edge and thus degrade its cutting ability. Finally, it should be mentioned that the friction and wear properties of a component consisting of a stack of layers is always dominated by the final layer that is exposed to the friction/wear partner. Thus, for a razor blade, the final PTFE layer enhances the friction properties. Since this layer is soft, it may be worn down rather fast in time and the DLC hard coating layer is then exposed to the friction partner. Unfortunately, the exposed DLC layer exhibits excellent wear resistance, but worse friction properties than the PTFE layer. Thus, the blade starts losing its performance although the cutting edge remains undamaged.

Another technical approach to optimize the friction properties of a cutting element is to reduce the contact surfaces as in the well-known cheese knife application. For safety reasons additional coatings on steel cheese knifes are not recommended. Thus, macroscopic sized holes are brought in the steel knife body. Such holes reduce the contact surface to the cheese and thus the friction property of the knife.

There is a continuing need to improve and to tailor the friction and wear properties of contact surfaces in absence of lubricants, especially in cutting applications.

The present invention therefore addresses the mentioned drawbacks in the prior art and provides a composite of a substrate coated with a structured coating wherein the composite shows a tailored friction and wear properties due to the structure of the coating surface.

This problem is solved by the composite of a substrate coated with a structured coating with the features of claim 1, the cutting element with the features of claim 11 and the method for producing a cutting element with the features of claim 14. The further dependent claims define preferred embodiments.

The following definitions are used in the present application:

### Recess:

A recess is formed by the removal or absence of material from the surface and extending below the surface of a solid host material (substrate or coating) so that the recess is devoid of the host material and open to the surroundings and accessible from the surface, i.e., it could be filled with another gaseous, liquid or solid substance or left empty. A recess has an opening with a perimeter in the surface of the host material, a base within the host material and a side wall within the host material that connects the perimeter of the opening to the base.

### Protrusion:

A protrusion is formed by the addition or presence of material on a surface and extends beyond the surface of a solid host material (substrate or coating).

### Largest inner circle:

The largest inner circle is a circle that can be fully fitted into any 2-dimensional planar shape that has a closed outer perimeter including circles, oval shapes or polygons. The largest inner circle will coincide with the perimeter of the closed 2-dimensional planar shape in each least 3 points and it will not extend beyond the perimeter at any point.

### Depth (of recess):

The depth d_{base} of a recess is the vertical distance from the surface of the host material (substrate or coating) to the lowest point on the base of the recess within the host material. The depth d_{pair-sub} and d_{pair-coat} of a pair of recesses is the average depth of two recesses that are adjacent to each other.

### Width (of recess):

The width w_{sub} and w_{coat} of a recess in the substrate and the coating, respectively, is the diameter of the largest inner circle that can be fully fitted into the perimeter of the opening of the recess in the surface plane of the host material (substrate or coating). The width w_{pair-sub} and w_{pair-coat} of a pair of recesses is the average width of two recesses that are adjacent to each other.

### Undercut:

An undercut refers to the shape of the side wall of a recess which has at least one width below the substrate surface that is greater than the width of the opening of the recess w_{sub} and w_{coat}, respectively. The maximum width wₘₐₓ is the diameter of the largest inner circle that can be fully fitted into the largest perimeter of the recess in a plane parallel to the surface of the host material (substrate) at a depth dₘₐₓ which is a depth below the surface of the substrate and above or at the depth d_{base} of the base of the recess.

### Spacing (of recesses):

The spacing s is the distance between any two adjacent recesses measured between the centres of the two adjacent recesses, whereby the centre of a recess is defined as the centre of the largest inner circle that fully fits into the perimeter of the recess opening at the substrate surface.

### Region:

The surface of the substrate may be subdivided into a plurality of smaller areas that are referred to as regions.

The term "comprising" in the claims and in the description of this application has the meaning that further components are not excluded. Within the scope of the present invention, the term "consisting of" should be understood as preferred embodiment of the term "comprising". If it is defined that a group "comprises" at least a specific number of components, this should also be understood such that a group is disclosed which "consists" preferably of these components.

According to the present invention a composite of a substrate coated with a structured coating comprising a substrate with a surface in contact with the coating is provided wherein the composite comprises or consists of a substrate with a surface in contact with the coating. The substrate has a plurality of substrate recesses at least in regions of the substrate surface and the coating extends into the recesses of the substrate. The coating has an inner surface being in contact with the substrate and an outer surface opposite to the inner surface, and the coating comprises at the outer surface a plurality of reproduced coating recesses being smaller than the recesses at the surface of the substrate resulting in a structured coating wherein the outer surface of the structured coating has a total surface area Aₜₒₜ, a total recess area Aᵣ and a contact area A_{c} = Aₜₒₜ - Aᵣ with the proviso that A_{c}/Aₜₒₜ is in a range of 0.1 to 0.8, preferably 0.3 to 0.7 and more preferably 0.45 to 0.65.

Creating such a structured surface of the substrate has the advantage that the friction properties can be controlled. The friction properties can be optimised by selecting the width, depth, spacing and shape of the recesses or protrusions. The distribution may be regular or random.

It is preferred that at least in regions of the composite the substrate is removed thereby exposing protrusions, which preferably have the inverse shape of the recesses at the inner surface of the coating.

According to a preferred embodiment, the substrate recesses have a width w_{sub} in a range of 100 nm to 100 µm, preferably from 500 nm to 20 µm, and a depth d_{base}, in a range 50 nm to 5 µm, preferably from 100 nm to 2 µm , with the proviso that the ratio w_{sub}/d_{base} is in the range from 0.20 to 25, preferably in the range from 1 to 20, and more preferably in the range from 5 to 15

Moreover, it is preferred that the coating recesses have a width w_{coat}, which is preferably in a range of 100 nm to 100 µm, more preferably from 500 nm to 20 µm, and a depth d_{coat}, which is preferably in a range 10 nm to 4 µm, more preferably from 50 nm to 1.5 µm, with the proviso that the ratio w_{coat}/d_{coat} is in the range from 0.25 to 25, preferably in the range from 1 to 20, and more preferably in the range from 5 to 15. It is preferred that d_{coat} is smaller than d_{base}.

According to a preferred embodiment, the substrate recesses are arranged such that the ratio w_{pair-sub/}s of the average width w_{pair-sub} of any pair of two adjacent substrate recesses to the spacing s of the same pair of two adjacent recesses is in the range of 0.1 to 0.95, preferably 0.3 to 0.9, more preferably 0.4 to 0.8, and even more preferably 0.5 to 0.75.

Moreover, it is preferred that the coating recesses are arranged such that the ratio w_{pair-coat}/s of the average width w_{pair-coat} of any pair of two adjacent coating recesses to the spacing s of the same pair of two adjacent recesses is in the range of 0.1 to 0.95, preferably 0.3 to 0.9, more preferably 0.4 to 0.8, and even more preferably 0.5 to 0.75.

In a preferred embodiment of the invention the substrate recesses are arranged such that the ratio s/d_{pair-sub} of the spacing s of any pair of two adjacent recesses to the average depth d_{pair-sub} of the same pair of tow recesses is preferably in the range from 0.25 to 20, more preferably in the range from 0.5 to 15, and even more preferably in the range from 1 to 12.

In a preferred embodiment of the invention the coating recesses are arranged such that the ratio s/d_{pair-coat} of the spacing s of any pair of two adjacent recesses to the average depth d_{pair-coat} of the same pair of tow recesses is preferably in the range from 0.25 to 20, more preferably in the range from 0.5 to 15, and even more preferably in the range from 1 to 12.

The recesses may be arranged regularly or randomly whereby the spacing s of any pair of substrate recesses and the coating recesses is identical.

It is preferred that the substrate comprises or consists of a material selected from the group
- metals, preferably titanium, nickel, chromium, niobium, tungsten, tantalum, molybdenum, vanadium, platinum, germanium, iron, and alloys thereof, in particular steel,
- ceramics comprising at least one element selected from the group consisting of carbon, nitrogen, boron, oxygen or combinations thereof, preferably silicon carbide, zirconium oxide, aluminum oxide, silicon nitride, boron nitride, tantalum nitride, TiAIN, TiCN, and/or TiB₂,
- glass ceramics; preferably aluminum-containing glass-ceramics,
- composite materials made from ceramic materials in a metallic matrix (cermets),
- hard metals, preferably sintered carbide hard metals, such as tungsten carbide or titanium carbide bonded with cobalt or nickel,
- single crystalline silicon or germanium, preferably with the crystalline plane parallel to the first surface, wafer orientation <100>, <110>, <111> or <211>,
- glass or sapphire,
- polycrystalline or amorphous silicon or germanium,
- mono- or polycrystalline diamond, diamond like carbon (DLC), adamantine carbon and
- combinations thereof,

More preferably, the substrate comprises or consists of silicon, steel and combinations thereof.

The steels used for the substrate are preferably selected from the group consisting of 1095, 12C27, 14C28N, 154CM, 3Cr13MoV, 4034, 40X10C2M, 4116, 420, 440A, 440B, 440C, 5160, 5Cr15MoV, 8Cr13MoV, 95X18, 9Cr18MoV, Acuto+, ATS-34, AUS-4, AUS-6 (= 6A), AUS-8 (= 8A), C75, CPM-10V, CPM-3V, CPM-D2, CPM-M4, CPM-S-30V, CPM-S-35VN, CPM-S-60V, CPM-154, Cronidur-30, CTS 204P, CTS 20CP, CTS 40CP, CTS B52, CTS B75P, CTS BD-1, CTS BD-30P, CTS XHP, D2, Elmax, GIN-1, H1, N690, N695, Niolox (1.4153), Nitro-B, S70, SGPS, SK-5, Sleipner, T6MoV, VG-10, VG-2, X-15T.N., X50CrMoV15, ZDP-189.

A martensitic stainless steel substrate is preferred for the production of cutting elements such as cutlery, surgical knives, and razor blade applications because it has high hardness and good corrosion resistance. Particularly, a high-carbon martensitic stainless steel strip material containing Cr in an amount of about 13% by mass is preferred as a material for razor blades.

The substrate material preferably has a thermal expansion coefficient of 0.9 to 20 ppm/K (at 20°C), more preferably of 1 to 15 ppm/K and even more preferably from 2 to 5 ppm/K.

The substrate has preferably a Young's modulus of 50 to 1000 GPa, more preferably of 75 to 800 GPa and even more preferably from 100 to 400 GPa.

It is preferred that the coating comprises or consists of a material selected from the group consisting of hard materials (hard coatings) like
- oxides, nitrides, carbides, borides, preferably aluminum nitride, chromium nitride, titanium nitride, titanium carbon nitride, titanium aluminum nitride, cubic boron nitride
- boron aluminum magnesium
- carbon, preferably diamond, nano-crystalline diamond, micro-crystalline diamond, polycrystalline diamond, mono-crystalline diamond, diamond like carbon (DLC) like tetrahedral amorphous carbon,

Moreover, all materials cited in the VDI guideline 2840 can be chosen for the hard coating material.

Alternatively, it is preferred that the coating comprises or consists of a material selected from the group consisting of soft materials (soft coatings) like low-friction materials, preferably selected from the group consisting of polymers, in particular fluoropolymers (preferably polytetrafluoroethylene (PTFE)), silicon-based polymers (preferably silicones), parylene, polysilazanes, polyvinylpyrrolidone, polyethylene, polypropylene, polymethyl methacrylate, graphite, and combinations thereof.

It is particularly preferred to use a hard coating material of nano-crystalline diamond and/or multilayers of nano-crystalline and coarse-grained polycrystalline diamond as coating material. Relative to monocrystalline diamond, it has been shown that production of nano-crystalline diamond, compared to the production of monocrystalline diamond, can be accomplished substantially more easily and economically. Moreover, with respect to their grain size distribution nano-crystalline diamond layers are more homogeneous than coarse grained polycrystalline diamond layers, the material also shows less inherent stress. Consequently, macroscopic distortion of a cutting element produced from nano-crystalline diamond is less probable.

It is also preferred that the substrate is coated with more than one coating, i.e. the coating is a first coating deposited on the substrate at least in regions and on the first coating at least one further coating is deposited at least in regions, preferably a second coating is deposited on the first coating or the outer surface of the first coating at least in regions.

It is preferred that the hard coating has a modulus of elasticity (Young's modulus) of less than 1200 GPa, preferably less than 900 GPa, more preferably less than 750 GPa and even more preferably from 50 GPa to 500 GPa. Due to the low modulus of elasticity the hard coating becomes more flexible and more elastic. The Young's modulus for diamond materials is determined according to the method as disclosed in Markus Mohr et al., "Youngs modulus, fracture strength, and Poisson's ratio of nanocrystalline diamond films", J. Appl. Phys. 116, 124308 (2014), in particular under paragraph III. B. Static measurement of Young's modulus.

The hard coating has a transverse rupture stress σ₀ of 1 GPa to 15 GPa, preferably of 2.5 GPa to 10 GPa, more preferably of 5 GPa to 8 GPa.

With respect to the definition of transverse rupture stress σ₀, reference is made to the following literature references:
- R.Morrell et al., Int. Journal of Refractory Metals & Hard Materials, 28 (2010), p. 508 -515
- R. Danzer et al. in "Technische keramische Werkstoffe", published by J. Kriegesmann, HvB Press, Ellerau, ISBN 978-3-938595-00-8, chapter 6.2.3.1 "Der 4-Kugelversuch zur Ermittlung der biaxialen Biegefestigkeit spröder Werkstoffe"

The transverse rupture stress σ₀ is thereby determined by statistical evaluation of breakage tests, e.g., in the B3B load test according to the above literature details. It is thereby defined as the breaking stress at which there is a probability of breakage of 63%.

Due to the extremely high transverse rupture stress of the hard coating material the detachment of individual crystallites from the hard coating is almost completely suppressed.

The hard coating has preferably a hardness 20 GPa to 100 GPa, preferably 25 GPa to 50 GPa. The hardness is determined by nanoindentation (Yeon-Gil Jung et. al., J. Mater. Res., Vol. 19, No. 10, p. 3076).

The hard coating at the contact surface A_{c} has preferably an average surface roughness R_{A} of 1 nm to 100 nm, more preferably 5 nm to 50 nm, and even more preferably 10 to 20 nm.

For a nano-crystalline diamond hard coating the average grain size d₅₀ of the nano-crystalline diamond of preferably 1 to 100 nm, more preferably from 5 to 90 nm, even more preferably from 7 to 30 nm, and most preferably from 10 to 20 nm. The average grain size d₅₀ is the diameter at which 50% of the second material is comprised of smaller particles. The average grain size d₅₀ may be determined using X-ray diffraction or transmission electron microscopy and counting of the grains. For coarse grained polycrystalline diamond the average grain size d₅₀ of the diamond film is preferably in the range from more than 100 nm to 1500 µm.

The hard coating has preferably a thermal expansion coefficient of 0.9 to 8 ppm/K (at 20°C), more preferably of 0.95 to 5ppm/K and even more preferably from 1.0 to 3 ppm/K.

The opening perimeter of the recesses may be of arbitrary shape, but the preferred shape of the recess opening has no corners., i.e., the recess opening perimeter is a closed continuous line without any singularities, preferably the recesses have a circular or ellipsoidal shape, but may also be of linear shape.

The recess preferably comprises a sidewall in the shape of an undercut, which means that the recess has at least one width below the substrate surface that is greater than the width of the opening of the recess w_{sub}. This improves the mechanical interlocking of the coating layer with the substrate material because some of the coating material will fill the undercut in the substrate material and thus be located beneath the first surface of the substrate. This increases the adhesion between the substrate and the coating because separation of the coating layer from the substrate material would require breaking some of the substrate material near the first surface away.

It is preferred that the coating has a thickness T_{c} of 100 nm to 50 µm, preferably 150 nm to 20 µm, more preferably 200 nm to 15µm.

The substrate has a preferably a thickness Tₛ of 20 to 2000 µm, more preferably 30 to 1000 µm, and even more preferably 50 to 400 µm.

According to a preferred embodiment, the composite has a total thickness Tₜₒₜ of 25 to 2050 µm, preferably 35 to 1000 µm, and more preferably 55 to 400 µm.

It is preferred that the ratio d_{base}/T_{c} of the depth d_{base} of the recesses in the substrate to the thickness of the coating T_{c} is in a range of 0.01 to 15, preferably 0.1 to 5, more preferably 0.5 to 2.

It is further preferred that the ratio d_{coat}/T_{c} of the depth d_{coat} of the recesses in the coating to the thickness of the coating T_{c} is in a range of 0.01 to 5, preferably 0.02 to 1, more preferably 0.05 to 0.5.

According to a further aspect of the present invention, a cutting element with a cutting edge is provided which is formed from the composite as described above. The cutting element is preferably a knife blade, razor blade, scalpel, knife, machine knife in slitting-, burst- and crash cutting systems, scissors or shear cutting systems.

It is preferred that the regions in which the substrate is removed thereby exposing protrusions being the inverse structure of the recesses is the region of the cutting edge of the cutting element, preferably the region extending up to 200 µm from the cutting edge.

Cutting edges may be produced by partially removing the substrate material until only the coating material (which is preferably a hard coating) remains and subsequently forming a cutting edge in the free-standing coating layer. If the substrate material contains recesses in its surface, the coating layer contains protrusions that were formed during the coating process when the coating materials filled the recesses in the substrate material. These protrusions mirror the shape and distribution of the recesses that were created in the surface of the substrate material prior to depositing the coating layer and will reduce the contact area of the surface to tailor the friction properties. The coating comprises a plurality of coating recesses at the coating surface that have been transferred from the plurality of recesses on the substrate surface and will reduce the contact area of the coating surface to tailor the friction properties.

According to a further aspect of the present invention also a cutting element with a cutting edge is provided formed a composite of a substrate coated with a structured coating comprising a substrate with a surface in contact with the coating is provided wherein the composite comprises or consists of a substrate with a surface in contact with the coating wherein the substrate has a plurality of substrate recesses at least in regions of the substrate surface and the coating extends into the recesses of the substrate. The coating has an inner surface being in contact with the substrate and an outer surface opposite to the inner surface. Moreover, the composite comprises regions in which the substrate is removed thereby exposing protrusions, which preferably have the inverse shape of the recesses at the inner surface of the coating. The cutting element comprises a cutting bevel and a cutting element body whereby the cutting bevel is at least partially located in the regions of the composite where the substrate is removed and the coating has exposed protrusions at the inner coating surface.

According to a further aspect of the present invention a method for producing a cutting element is provided which comprises the following steps:
a) Providing a substrate with a first surface,
b) forming an etching mask with openings at the surface of the substrate,
c) etching the substrate through the openings in the etching mask to form a plurality of recesses at the first surface of the substrate by reactive ion etching or wet chemical etching,
d) optionally, removing the etching mask from the substrate
e) depositing a coating onto the substrate surface and into the plurality of recesses thereby transferring the substrate recesses into coating recesses at the outer surface of the coating which are smaller than the substrate recesses resulting in the structured coating,
f) etching the substrate thereby exposing protrusions at the inner surface of the coating forming a cutting bevel of the cutting element.

In a preferred embodiment, after step c) the etching mask is removed from the substrate.

The present invention is further illustrated by the following figures and examples which show specific embodiments according to the present invention. However, these specific embodiments shall not be interpreted in any limiting way with respect to the present invention as described in the claims in the general part of the specification.
- Fig. 1a to c: show a top view, cross section and enlarged cross section of a recess, respectively.
- Fig. 2: shows a cross section of a composite of the present invention.
- Fig. 3: is a top view of a substrate onto the surface.
- Fig. 4: is a cross-section of a substrate of the present invention.
- Fig. 5a to c: are scanning electron microscopic (SEM) images of the substrate and the coating surface according to the present invention.
- Fig. 6: shows alternative recess shapes according to the present invention.
- Fig. 7: is a schematic illustration of the process steps of the method according to the present invention.
- Fig. 8a to d: are schematic illustrations of the deposition of the coating layer onto a substrate material according to the present invention.
- Fig. 9: shows schematic top and side views of a cutting element at different stages during the process according to the present invention.
- Fig. 10: shows schematic cross-sections of the formation of a cutting element in the hard coating.
- Fig. 11a to c: shows SEM photographs of perspectives of a cutting element with circular shaped recesses with in different scales.
- Fig. 12a to b: shows SEM photographs of perspectives of a cutting element with linear shaped recesses in different scales.
- Fig. 13a to b: shows scanning electron photographs in different magnifications of a cross section in a perspective view of a cutting element.

### Reference sign list

- 10: composite
- 110: interface
- 20: substrate (material)
- 200: substrate surface
- 205: substrate backside surface
- 210: photoresist
- 220: exposed photoresist regions
- 230: unprotected regions
- 240: region with recesses
- 250: region without recesses
- 30: coating (layer)
- 300: coating surface
- 305: coating inner surface
- 320: protrusion
- 330: coating recess
- 40, 40', 40", 40‴: recesses
- 410: recess opening
- 415: side wall
- 420: recess base
- 460: recess opening perimeter
- 462: recess maximum perimeter
- 470: largest inner circle
- 472: recess centre
- 480: undercut
- 600: cutting element
- 610: cutting edge
- 620: cutting bevel
- 630: cutting element body

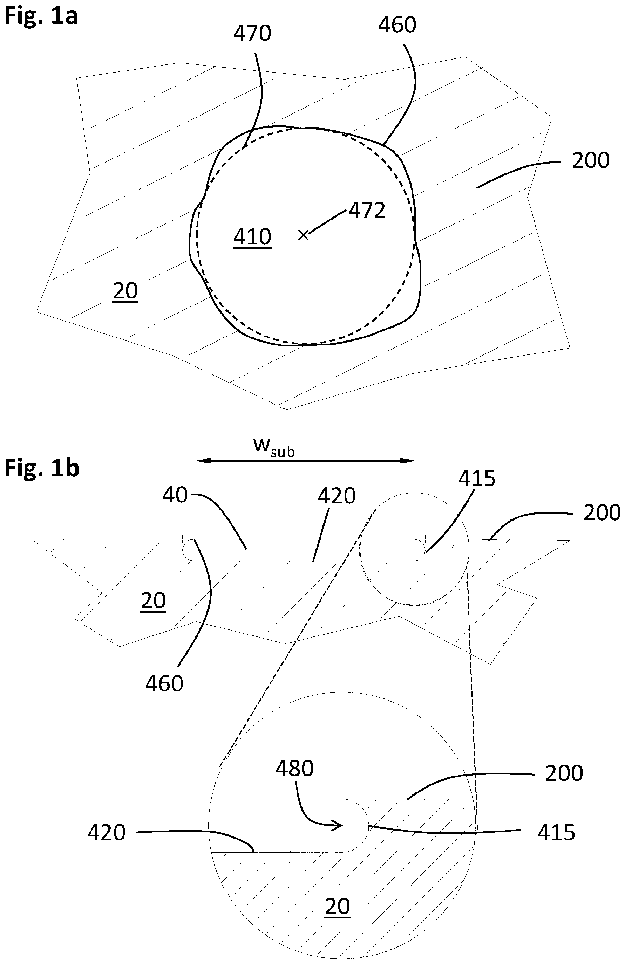

Fig. 1a shows the top view of a recess 40 in a substrate 20. The recess 40 has an opening 410 with an opening perimeter460, both of which lie in the surface 200 of substrate 20. The opening perimeter 460 may be of arbitrary shape, but the preferred shape of the recess opening 410 has no corners, i.e., the recess opening perimeter 460 is a closed continuous line without any singularities. The width w_{sub} of the recess is the diameter of the largest inner circle 470 that can be fitted fully within the perimeter 460 of the opening 410 as shown by the dotted line in Fig. 1a. The circumference of this largest inner circle 470 may coincide with the perimeter 460 of the recess opening 410 but may not exceed beyond the perimeter 460 of the recess opening 410. The centre of the largest inner circle 470 defines the recess centre 472 of the recess.

Fig. 1b shows the cross section of the recess 40 in a substrate 20 from Fig. 1a. The recess 40 comprises an opening located in the surface 200 of the substrate 20, and a base 420 and a side wall 415 located within the substrate 20. The opening has a width w_{sub} as defined by the largest inner circle 470.

As can be seen form the enlargement of the side wall 415, the side wall 415 has an undercut 480. This results in the recess 40 having a width at a depth below the substrate surface 200 that is greater than the width w_{sub} of the opening of the recess 40 at the substrate surface 200. The width of the recess 40 at any depth below the substrate surface 200 is defined by the diameter of the largest inner circle that can be entirely placed within the perimeter of the recess at this depth below the substrate surface 200 whereby the perimeter lies within a plane parallel to the substrate surface at this depth.

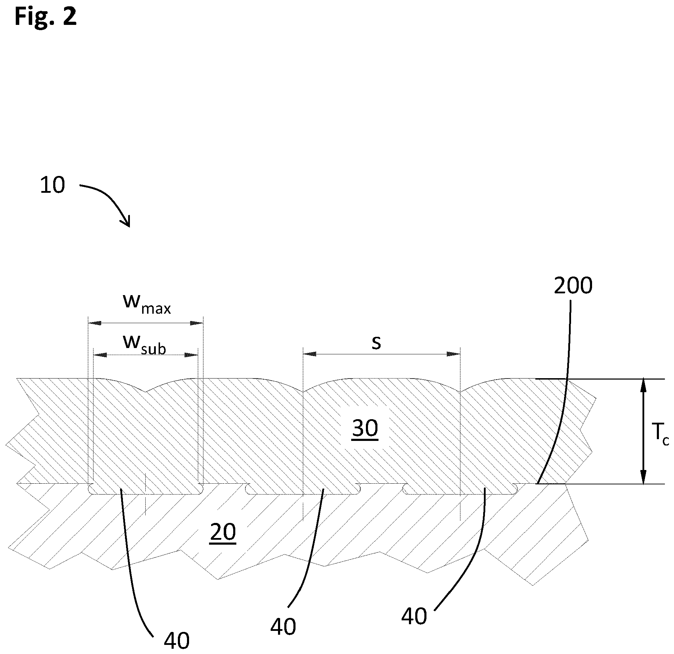

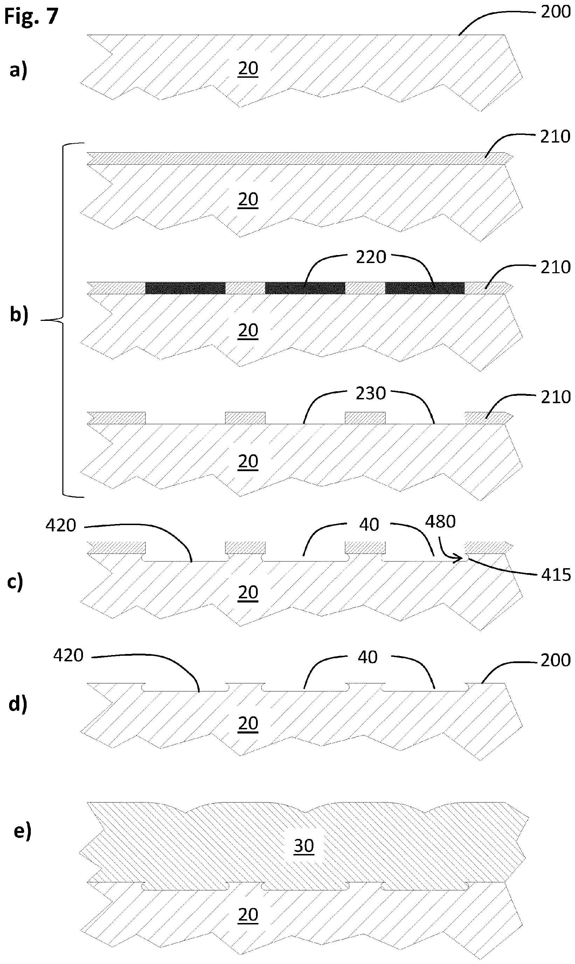

Fig. 2 shows a cross-sectional view of a composite 10 comprising a substrate material 20 and a coating layer 30. The substrate material 20 is made of silicon. The substrate material 20 has a surface 200. The substrate material 20 comprises a plurality of recesses 40, which have been etched into the surface 200 according to the method described below and illustrated in Fig. 7. Each recess 40 has an opening at the surface 200 with a width w_{sub}. Furthermore, each recess 40 has a maximum width wₘₐₓ at a depth dₘₐₓ below the surface 200. Adjacent recesses 40 are separated by a spacing s. The coating layer 30 consists of nanocrystalline diamond. The coating layer 30 is deposited onto the structured surface 200 of the substrate material 20 according to the method described below and illustrated in Fig. 7. The coating layer 30 has a coating thickness T_{c} as measured form the substrate surface 200.

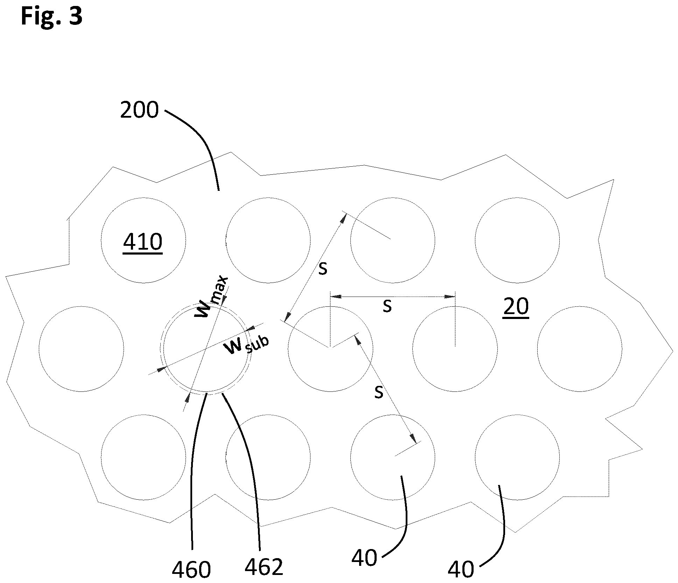

Fig. 3 shows a top view of the surface 200 of a substrate material 20. The substrate material 20 comprises a plurality of recesses 40, which have been etched into the surface 200 according to the method described below and illustrated in Fig. 7. Each recess 40 has an opening 410 at the surface 200 with a width w_{sub} and a recess opening perimeter 460 around the opening 410 of recesses 40. Furthermore, each recess 40 has a maximum width wₘₐₓ at a maximum depth dₘₐₓ below the surface 200. Adjacent recesses 40 are separated by a spacing s.

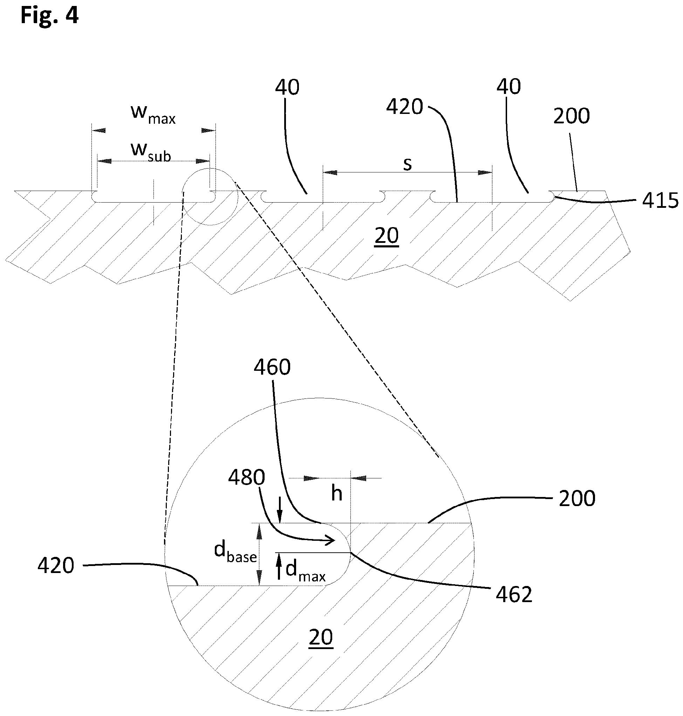

Fig. 4 shows a cross sectional view of a substrate material 20. The substrate material 20 comprises a plurality of recesses 40, which have been etched into the surface 200 according to the method described below and illustrated in Fig. 7. Each recess 40 has an opening at the surface 200, a sidewall 415 and a base 420 at a depth d_{base} below the surface 200.

As can be seen form the magnification of a sidewall 415 of a recess 40, an opening perimeter 460 is located around the opening of recesses 40. Furthermore, each recess 40 has a maximum perimeter 462 at a maximum depth dₘₐₓ below the surface 200. The largest inner circle that can be fully fitted into the opening perimeter 460 defines the surface width w_{sub} and the largest inner circle that can be fully fitted into the maximum perimeter462 defines the maximum width wₘₐₓ. The difference of wₘₐₓ minus w_{sub} corresponds to the twice the width of the overhang h. The depth dₘₐₓ is greater than zero but less or equal than the depth d_{base} of the recess 40, meaning that the maximum perimeter 462 and hence maximum width wₘₐₓ is located below the surface 200 of the substrate 20 to form and undercut 480. Adjacent recesses 40 are separated by a spacing s.

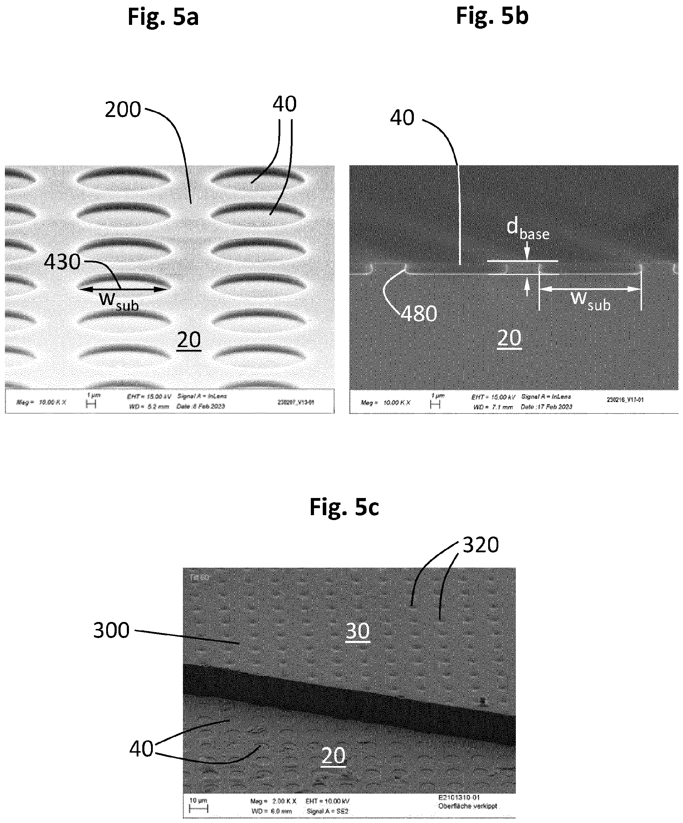

Fig. 5a shows a perspective scanning electron micrograph (SEM) of a surface 200 of a substrate material 20 comprising a plurality of circular recesses 40. As can be inferred from the scale bar, the opening width w_{sub} of recesses 40 is approx. 10 µm in this example.

Fig. 5b shows a cross section SEM of a substrate material 20 comprising a plurality of circular recesses 40 with undercuts 480. As can be seen from the scale bar and measurement, the opening width w_{sub} of recesses 40 is approximately 10 µm and the recess depth d_{base} is approximately 1 µm in this example.

Fig. 5c shows a perspective SEM of a composite 10 comprising a coating layer 30 and substrate material 20 with a plurality of recesses 40 where the coating layer has been partially removed. After depositing a coating layer onto a substrate surface that contains a plurality of recesses, these recesses transfer to the surface of the coating layer 300 and form a plurality of coating recesses 330.

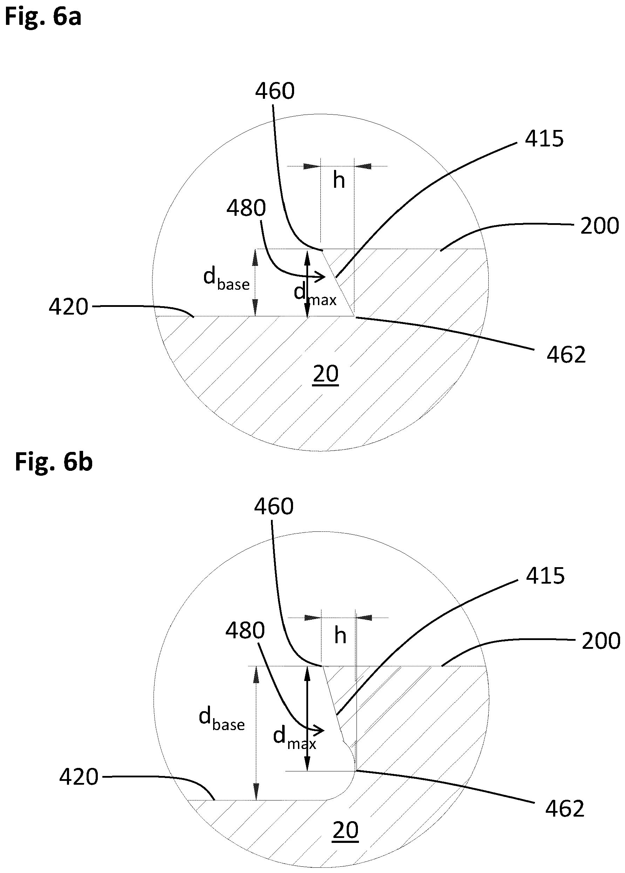

Fig. 6a and 6b show two alternative magnifications of sidewalls 415 of recesses 40.

As can be seen in Fig. 6a, the recess 40 has an undercut 480 with a straight sidewall 430 that increases the width of the recess from the opening towards the base 420. The opening perimeter 460 is located around the opening of recess 40, the maximum perimeter 462 is located at a maximum depth dₘₐₓ below the surface 200, which in this example equals the recess depth d_{base}. The largest inner circle that fully fits into the opening perimeter 460 defines the surface width w_{sub} and the largest inner circle that fully fits into the maximum perimeter 462 defines the maximum width wₘₐₓ 432. The difference of wₘₐₓ minus w_{sub} corresponds to the twice the width of the overhang h.

As can be seen in Fig. 6b, recess 40 has an undercut 480 with a sidewall 415 of varying shape. The opening perimeter 460 is located around the opening of recess 40, the maximum perimeter 462 is located at a maximum depth dₘₐₓ below the surface 200. The depth dₘₐₓ is greater than zero but less or equal than the depth d_{base} of the recess 40, meaning that the maximum perimeter 462 and hence maximum width wₘₐₓ is located between the substrate surface 200 and the recess base 420.

The largest inner circle that fully fits into the opening perimeter 460 defines the surface width w_{sub} and the largest inner circle that fully fits into the maximum perimeter 462 defines the maximum width wₘₐₓ. The difference of wₘₐₓ minus w_{sub} corresponds to the twice the width of the overhang h.

To form an undercut 480, the sidewall 415 of recess 40 can have any shape if a depth dₘₐₓ exists at which the width wₘₐₓ of the recess is greater than the width w_{sub} at the opening of the recess, i.e., an overhang h exists that is greater than zero.

### Example

The inventive process for producing a composite of a substrate with a structured coating is shown in the diagram of Fig. 7 and explained in detail in the following.

Process step a) shows the starting point, providing a single crystal silicon wafer as the substrate.

After cleaning the substrate surface 200 carefully in step b) a photoresist 210 providing a reasonable selectivity against the reactant etch gas composition is deposited by spin coating or spraying to achieve a reasonable thickness (e.g., 1 to 2 µm) and homogeneity. To obtain a reasonable resolution and selectivity, standard photoresists for semiconductor fabrication are recommended.

The photoresist is dried / prebaked according to the recommended parameters provided by the photoresist manufacturer. To pattern the photoresist, a photolithographic mask and an UV Exposure apparatus are needed. The photoresist is exposed through the photoresist mask and the exposed photoresist regions 220 are developed according to the recommended parameters provided by the photoresist manufacturer.

After development, a post bake may be recommended to increase the selectivity of the following etching process. Processing of the photoresist is schematically shown in process steps b).

The recesses 40 are formed by isotropic etching of the unprotected regions 230 on the substrate, utilizing the photoresist 210 as mask with sufficient stability against the reactants. If a small recess depth is required, it is advantageous to utilize dry etching processes such as (D)RIE or ICP. In case of a silicon substrate, advantage can be taken from DRIE adapted processes, alternating side wall passivation and isotropic etching steps. Details can be found e.g., in M. D. Henry, "ICP Etching of silicon for micro and nanoscale devices", Thesis California Institute of Technology, May 19, 2010. Such steps allow for a precise control of a desired shape of the sidewall 415 and an undercut 480. This process is shown in process step c).

After recess 40 formation, the photoresist 210 is removed utilizing the recommended solutions by the photoresist manufacturer, shown in process step d).

A coating process is performed using a planar silicon substrate (e.g., wafer) coated with a 10 µm thick nanocrystalline diamond CVD film. As the diamond growth or deposition, respectively, does not spontaneous start on a clean silicon surface, a nucleation step (not shown) must be performed in advance. Here, a water-based nucleation slurry containing purified diamond particles (seeds) are used. The size of the seeds should be much smaller than the recess depth d_{base} to enable a high nucleation density. The nucleation process is performed by dipping the Silicon wafer into the slurry and followed by a water-based rinsing and a drying step.

After nucleation, the wafer is placed e.g., in a hot filament CVD system and the growth process is started. The hot filament CVD growth of diamond is known to be rather isotropic as no ion bombardment is involved. Thus, the recessed silicon surface is overgrown or covered, respectively, and the residual diamond growth surface smoothens out with increasing diamond film thickness as seen in the cross-sectional SEM pictures of Fig. 5c. Process step e) shows schematically the final result.

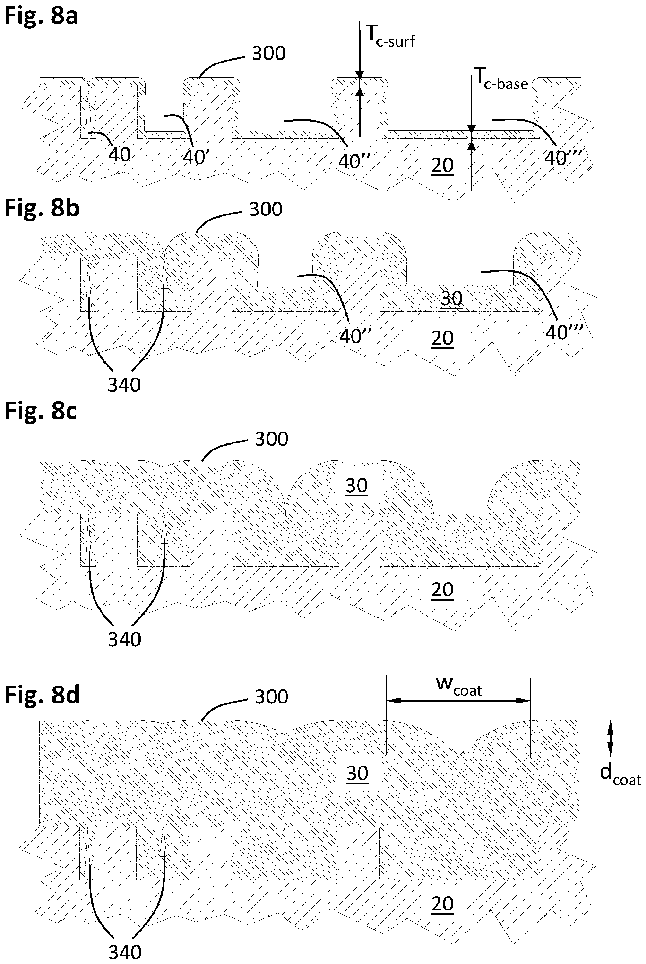

Figs. 8a to d illustrate the stages of the deposition of a coating layer onto a structured substrate 20 that contains a plurality of recesses (40, 40, 40", 40‴) with different widths to illustrate the importance to choose the correct recess width w_{sub} and ratio w_{sub}/d_{base}. It has been found that the deposition rate strongly depends on this ratio w_{sub}/d_{base} and that the deposition rate at the recess base 420 is in general lower than the growth rate at the coating surface 300 resulting in different coating thicknesses T_{c-surf} and T_{c-base} (see fig. 8a). With increasing coating thickness (fig. 8b, 8c, 8d), the coating layer at the coating surface 300 may form a continuous layer before the recesses have been filled with the coating material which leads to the formation of cavities 340 in the coating layer 30. These cavities are undesirable because they reduce the adhesion between the substrate material 20 and the coating layer 30. Knowledge of the deposition rates makes it possible to choose the correct ratio of the recess width to the recess depth w_{sub}/d_{base}. For the CVD growth of nanocrystalline diamond a ratio w_{sub}/d_{base} in the range of 1 to 20 is preferred. The finally formed recesses have a width w_{coat} and a depth d_{coat} depending on the substrate width w_{sub}, the depth d_{base} and the thickness of the coating T_{c}.

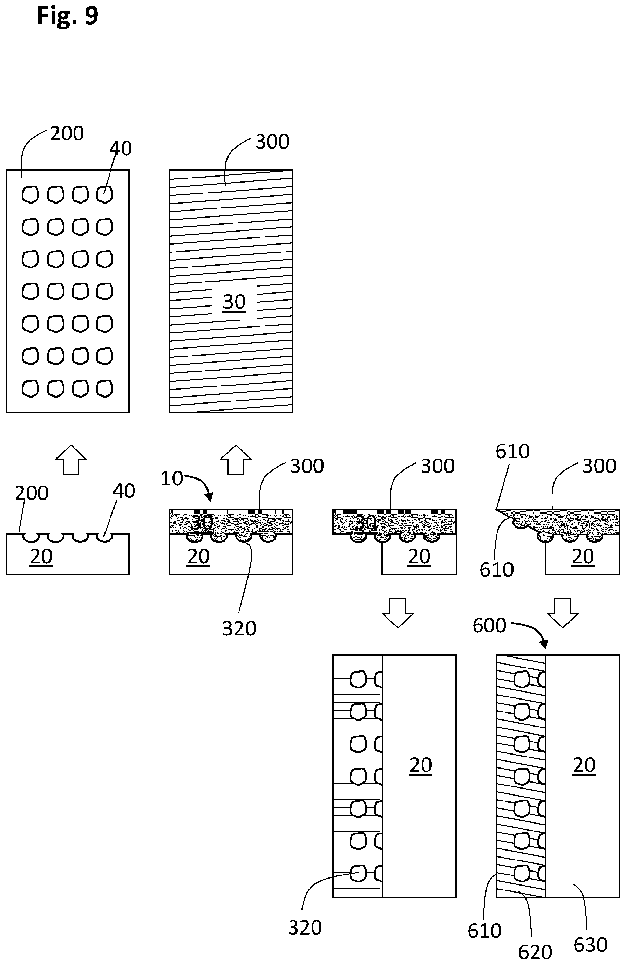

Fig. 9 shows a schematic top view and cross sections of a cutting element at different stages during the composite and cutting element making process. The cutting element 600 with a cutting edge 610 and a cutting element body 620 are produced from the layered composite 10, whereby the coating layer 30 comprises a hard coating from the selection of materials disclosed above. Cutting edges 610 may be produced by partially removing the substrate material 20 until only the coating layer 30 remains and subsequently forming a cutting edge 610 in the portion of the coating layer that is unsupported by substrate material. If the substrate material 20 contains recesses 40 on the surface 200, the coating layer 30 contains protrusions 320 that were formed during the coating process when the coating materials filled the recesses 40 in the substrate material 20. These protrusions 320 mirror the shape and distribution of the recesses 40 that were created in the surface 200 of the substrate material 20 prior to depositing the coating layer 30. However, in the case of cutting edges 610 formed in the unsupported coating layer 30 by partially removing the substrate material 20, it is desirable not to have protrusions 320 on the cutting edges 610. Protrusions 320 on the cutting edge 610 may cause the cutting edge 610 to be ragged and the cutting bevel 620 to be rough which may lead to poor cutting performance and instability of the cutting blade 600. It is therefore desirable to avoid protrusions 320 at the cutting edge 610, which requires that recesses 40 must not be created on the surface 200 of the substrate 20 in regions where the substrate 20 will be removed after the coating process to form cutting bevels 620 with cutting edges 610.

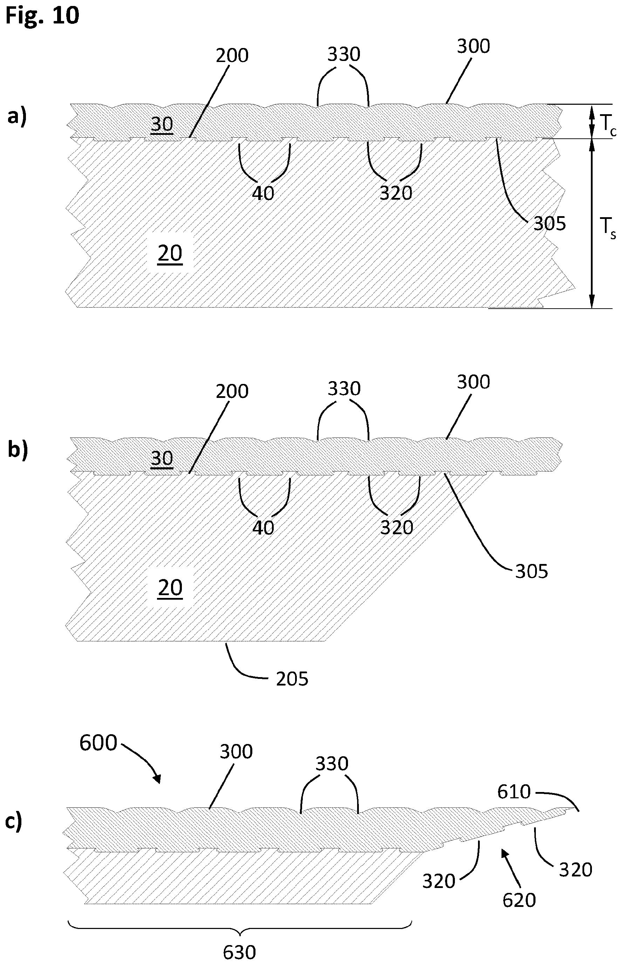

Fig. 10 shows the optional cutting edge formation process on a substrate surface 200 that has been structured to contain a plurality of recesses 40 so that a cutting element 600 with a cutting bevel 620 containing protrusions 320 and a cutting element body 630 with a coating surface 300 containing coating recesses 330 can be achieved.

The initial stage a) in Fig. 10 corresponds to step e) in Fig. 7, where a coating 30 with thickness T_{c} has been deposited onto a substrate 20 with thickness Tₛ and a plurality of recesses 40. The coating 30 comprises a plurality of coating recesses 330 at the coating surface 300 that have been transferred from the plurality of recesses 40 on the surface 200 of the substrate 20 and will reduce the contact area of the coating surface to tailor the friction properties. Furthermore, the coating 30 comprising protrusions 320 at the inner coating surface 305 that fill the recesses 40 in the substrate 20.

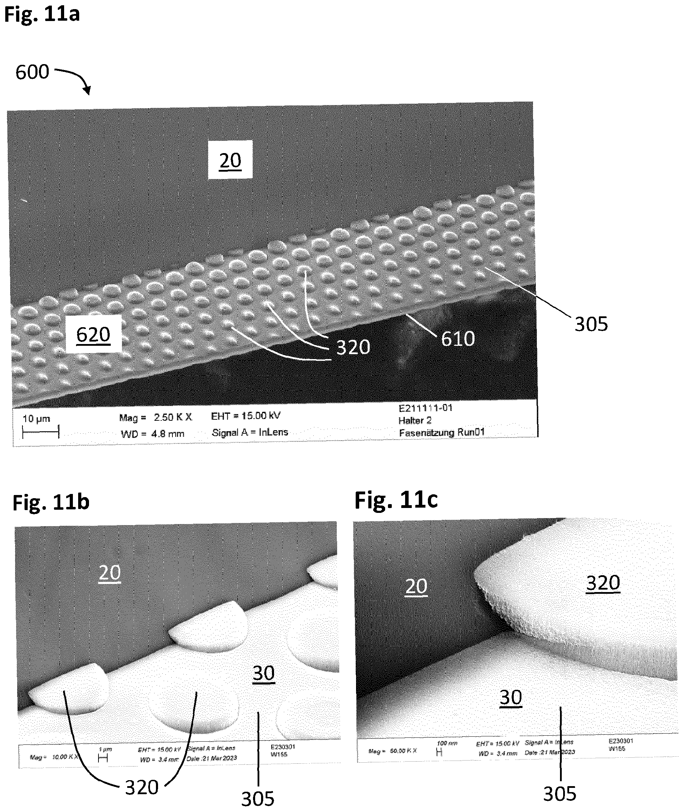

Fig. 11 shows an electron microscopy image of a cutting element 600 at 3 different magnifications. The inner coating surface 305 has been exposed on the cutting bevel 620 formed in the coating layer 30 after removing substrate material 20. A plurality of circular protrusions 320 can be seen on the inner coating surface 305 of the cutting bevel 620.

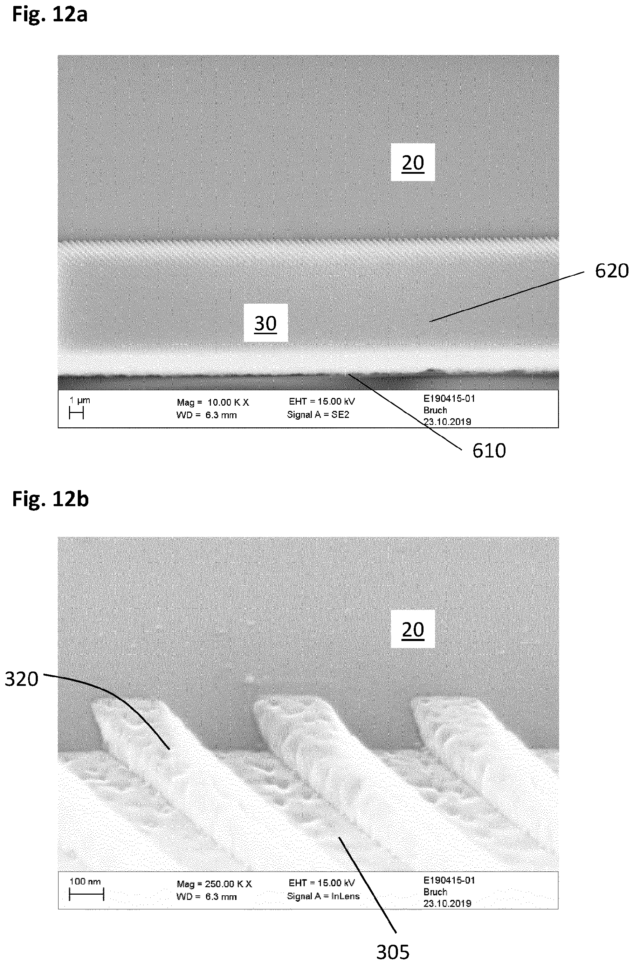

Fig. 12 shows an electron microscopy image of a cutting element 600 at 2 different magnifications. The inner coating surface 305 has been exposed on the cutting bevel 620 formed in the coating layer 30 after removing substrate material 20. In this case, a plurality of linear protrusions 320 can be seen on the inner coating surface 305 of the cutting bevel 620.

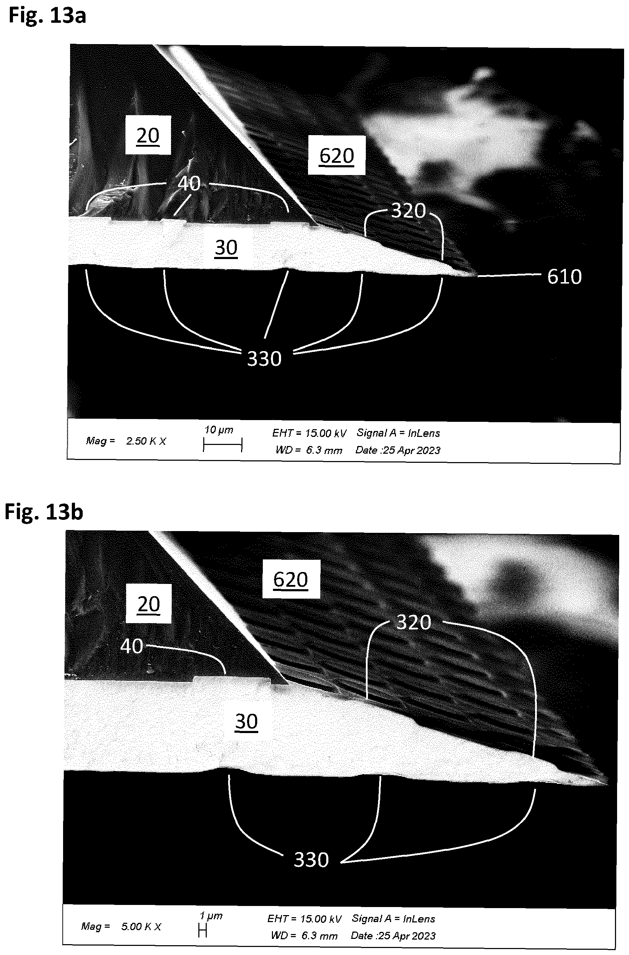

Fig 13 shows scanning electron photographs in different magnifications of a cross section in a perspective view of a cutting element according to the present invention. The width of the circular shaped recesses 40 w_{sub} is approx. 10µm, the spacing s is 15µm, the depth dₘₐₓ of recesses is approx. 1µm. Recesses 330 and protrusions 320 are originated in the recesses 40.

## Claims

1. Composite (10) of a substrate (20) with a structured coating (30) comprising or consisting of a substrate (20) with a surface in contact with a coating (30),
wherein the substrate (20) has a plurality of substrate recesses (40, 40', 40", 40‴) at least in regions of the substrate surface (200) and the coating (30) extends into the recesses (40, 40', 40", 40‴) of the substrate (20), and
the coating (30) has an inner surface (305) being in contact with the substrate and an surface (300) opposite to the inner surface, and
the coating (30) comprises at the surface (300) a plurality of coating recesses (330) being smaller than the recesses (40, 40', 40", 40‴) at the surface of the substrate (200) resulting in a structured coating (30),
wherein the surface of the structured coating (300) has a total surface area Aₜₒₜ, a total recess area Aᵣ and a contact area A_{c} = Aₜₒₜ - Aᵣ with the proviso that A_{c}/Aₜₒₜ is in the range of 0.1 to 0.8.

2. Composite of claim 1,
**characterized in that** at least in regions of the composite the substrate (20) is removed thereby exposing protrusions (320), which preferably have the inverse shape of the recesses (40, 40', 40", 40‴) at the surface of the substrate.

3. Composite of any one of claims 1 or 2,
**characterized in that** the substrate recesses (40, 40', 40", 40‴) have a width w_{sub} in a range of 100 nm to 100 µm, preferably from 500 nm to 20 µm, and a depth d_{base}, in a range 50 nm to 5 µm, preferably from 100 nm to 2 µm , with the proviso that the ratio w_{sub}/d_{base} is in the range from 0.20 to 25, preferably in the range from 1 to 20, and more preferably in the range from 5 to 15
and/or
the coating recesses (330) have a width w_{coat} in a range of 100 nm to 100 µm, preferably from 500 nm to 20 µm, and a depth d_{coat}, in a range 50 nm to 5 µm, preferably from 100 nm to 2 µm , with the proviso that the ratio w_{coat}/d_{coat} is in the range from 0.25 to 25, preferably in the range from 1 to 20, and more preferably in the range from 5 to 15,

4. Composite of any of claims 1 to 3,
**characterized in that** d_{coat} is smaller than d_{base}.

5. Composite of any of claims 1 to 4,
**characterized in that** A_{c}/Aₜₒₜ is in a range of 0.3 to 0.7 and preferably 0.45 to 0.65.

6. Composite of any of claims 1 to 5,
**characterized in that** the substrate recesses (40, 40', 40", 40‴) are arranged such that the ratio s/dₚₐᵢᵣ of the spacing s of any pair of two adjacent recesses to the average depth dₚₐᵢᵣ of the same pair of tow recesses is in the range from 0.25 to 20, preferably in the range from 0.5 to 15, and more preferably in the range from 1 to 12.

7. Composite of any of claims 1 to 6,
**characterized in that** the coating (30) is a first coating deposited on the substrate at least in regions and on the first coating at least one further coating is deposited at least in regions, preferably a second coating is deposited on the first coating or the outer surface of the first coating at least in regions.

8. Composite of any of claims 1 to 7,
**characterized in that** the recesses (40, 40', 40", 40‴) have a circular or ellipsoidal or linear shape, preferably the recess has a recess opening perimeter which is a closed continuous line without any singularities.

9. Composite of any of claims 1 to 8,
**characterized in that** the coating (30) has a thickness T_{c} of 100 nm to 50 µm, preferably 150 nm to 20 µm, more preferably 200 nm to 15µm and/or
the substrate (20) has a thickness Tₛ of 20 to 2000 µm, preferably 30 to 1000 µm, more preferably 50 to 400 µm and/or
the composite (10) has a total thickness Tₜₒₜ of 25 to 2050 µm, preferably 35 to 1000 µm, more preferably 55 to 400 µm.

10. Composite of any of claims 1 to 9,
**characterized in that** the ratio d_{base} /T_{c} of the depth d_{base} of the substrate recesses (40, 40', 40", 40‴) to the thickness of the coating (30) T_{c} is in a range of 0.01 to 15, preferably 0.1 to 5, more preferably 0.5 to 2
and/or
the ratio d_{coat} /T_{c} of the depth d_{coat} of the coating recesses (330) to the thickness of the coating (30) T_{c} is in a range of 0.01 to 5, preferably 0.02 to 1, more preferably 0.05 to 0.5.

11. Cutting element (600) formed from the composite (10) of any of the preceding claims, preferably a knife blade, razor blade, scalpel, knife, machine knife in slitting-, burst- and crash cutting systems, scissors or shear cutting systems.

12. Cutting element of claim 11,
**characterized in that** the regions of the composite (10) in which the substrate (20) is removed thereby exposing protrusions (320) being the inverse structure of the recesses (40, 40', 40", 40‴) is the region of the cutting bevel.

13. Cutting element of claim 11 or 12,
**characterized in that** the cutting element (600) comprises a cutting bevel (620) and a cutting element body (630) whereby the cutting bevel (620) is at least partially located in regions of the composite (10) where the substrate (20) is removed and has exposes protrusions (320) at the inner coating surface (305).

14. A method for producing a cutting element (600) with the steps of:
• Providing a substrate (20) with a surface (200),
• forming an etching mask with openings at the substrate surface (200),
• etching the substrate (20) through the openings in the etching mask to form a plurality of substrate recesses (40, 40', 40", 40‴) at the substrate surface (200) by reactive ion etching or wet chemical etching,
• optionally, removing the etching mask from the substrate (20),
• depositing a coating (20) onto the substrate surface (200) and into the plurality of recesses (40, 40', 40", 40‴) thereby transferring the substrate recesses (40, 40', 40", 40‴) into coating recesses (330) at the coating surface (300) which are smaller than the substrate recesses (40, 40', 40", 40‴) resulting in the structured coating (30),
• etching the substrate (20) thereby exposing protrusions (320) at the inner coating surface (305) forming a cutting bevel (620) of the cutting element (600).
